# EUROPEAN PATENT APPLICATION

(11) **EP 4 675 668 A1**
(43) Date of publication of application: **07.01.2026**
(21) Application number: 24275080.0
(22) Date of filing: 04.07.2024
(51) Int. Cl.: H01J 37/32, H01J 37/34

(54) **SPUTTERING APPARATUS AND METHOD**

(71) Applicant: BAE SYSTEMS plc, London SW1Y 5AD (GB)
(72) Inventor: The designation of the inventor has not yet been filed
(74) Representative: BAE SYSTEMS plc Group IP Department

(57) **Abstract**

A sputtering apparatus (1) comprising a vacuum chamber (2) and a magnetron array (7). The magnetron array (7) comprising an array of two or more magnetrons (32, 36, 27) for bombarding associated sputtering targets (33, 38, 39). A method of magnetron sputtering using the apparatus (1) is also disclosed. The method comprising feeding a substate material past said magnetron array (7).

## Description

### Technical Field

The present disclosure relates to a sputtering apparatus and method of magnetron sputtering.

### Background

Magnetron sputtering is a known method for the deposition of thin layers of material on a substrate. In a typical magnetron sputtering apparatus, a single magnetron is used to apply a magnetic field around a target material. The magnetron, target and substrate upon which it is desired to deposit layers of atoms from the target material are contained in a vacuum chamber filled with an inert gas such as argon. The magnetron energises the inert gas to create a plasma, which in the case of argon as the inert gas, comprises argon ions and electrons. A DC voltage is applied between the target and the substate. The positively charged argon ions are accelerated and collide with the target. This causes atoms of the target material to be sputtered and deposited on the substrate.

The target material is typically a disc of material, which may include metals, metal alloys, and metal oxides amongst others. Known sputtering apparatuses can be used to apply thin films to substates such as the application of metallic coatings to polymer sheets such as those used for packaging perishable foodstuffs such as potato chips. However, the known sputtering apparatuses have limitations in form of the material deposition they can produce.

The present invention seeks to ameliorate, at least to a certain degree, the problems associated with the prior art.

### Summary

According to a first aspect of the disclosure, there is provided a sputtering apparatus comprising a vacuum chamber and a magnetron array comprising an array of two or more magnetrons for bombarding associated sputtering targets.

Advantageously, such an arrangements enables differing thicknesses of deposited material on the substrate in a single operation.

Optionally, said magnetron array comprises a linear array of magnetrons.

Optionally, said magnetron array comprises a rectangular or square array of magnetrons.

Optionally, the spacing between adjacent magnetrons in the magnetron array is adjustable.

Optionally, the height from a substrate of one or more of the magnetrons in the magnetron array is adjustable.

Optionally, the sputtering apparatus comprises a controller configured to control the voltage applied to each magnetron in said magnetron array.

Optionally, the sputtering apparatus comprises a feed roller for feeding a substrate material under said magnetron array.

Optionally, the feed roller comprises a reel to reel arrangement of rollers.

Optionally, the sputtering apparatus comprises a sliding feed tray.

According to a second aspect, there is provided a method of magnetron sputtering using the apparatus according to the first aspect or any optional feature thereof, the method comprising feeding a substate material past said magnetron array.

Optionally, the method including adjusting one or more of the power, height and spacing of the sputtering magnetrons in the magnetron array.

Optionally, the substate comprises a polymeric film or glass scrim.

Optionally, the method further includes introducing a non-inert gas into the chamber.

Optionally, a gas is introduced at or towards one side or at the end of the chamber to provide a gas gradient across the substrate as it moves through the chamber. This advantageously allows a gas gradient to be provided across the substrate.

Optionally, the method includes sputter etching and/or oxygen cleansing of the substrate.

### Brief Description of the Drawings

The present disclosure will now be described by way of example, by reference to and as illustrated in the accompanying drawings in which:
Figure 1 is a front view of an example sputtering apparatus;
Figure 2 is a rear view of the example sputtering apparatus of Figure 1;
Figure 3 is a feed roller for use within the example sputtering apparatus of Figure 1;
Figure 4 is a planar sliding tray for use with the example sputtering apparatus of Figure 1;
Figure 5 is a mechanical filter for use with the example sputtering apparatus of Figure 1;
Figure 6 is a schematic within the sputtering apparatus of Figure 1; and
Figure 7 is a further schematic within the sputtering apparatus of Figure 1.

### Detailed Description

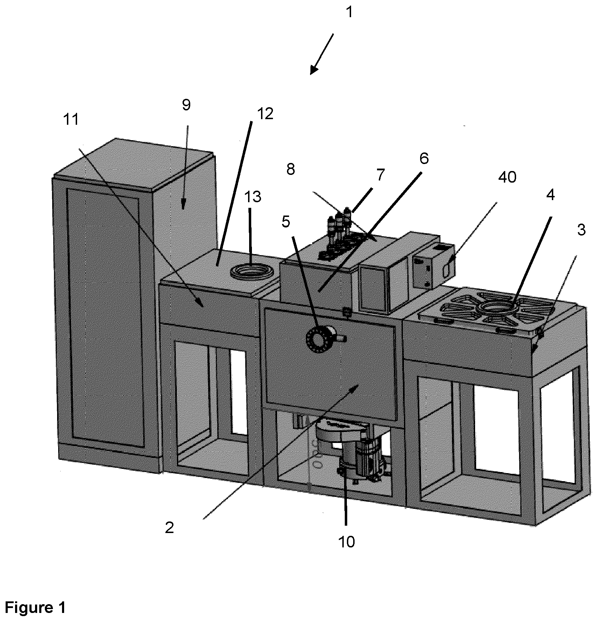

Figure 1 is a front view of an example sputtering apparatus shown generally at 1. The sputtering apparatus comprises a main chamber 2 which in the example has a volume of 400 litres. Adjacent to the main chamber 2 is a loading chamber 3, for the loading of planar substrates, which in the example has a capacity of 130 litres. The loading chamber is provided with a hinged lid 4 comprising a viewing port. The main chamber 2 includes an openable viewing port 5.

Above the main chamber 2, a top box 6 is provided for housing an array 7 of sputtering magnetrons. In the example apparatus, the array 7 comprising a linear array of three sputtering magnetrons. The sputtering magnetrons are supported by an hinged lid 8 on top box 6, which facilitates the replacement and maintenance of the sputtering magnetrons. A rectangular or square array of magnetrons could also be provided.

In the example, each sputtering magnetron in the array 7 is supplied by an independent DC 1kW power supply. The magnetrons in the array 7 can be individually controlled via a system controller housed in control rack 9. The control rack 9 may also house an internal power distribution unit with individual circuit breakers and the independent magnetron DC power supplies. A user display device and input device, such as a personal computer, may be provided external to the apparatus for user control of the apparatus.

The main chamber 2, in the example, is fitted with a turbo vacuum pump 10 operating for example at 1300 litres/second in order to evacuate the chamber of air.

The apparatus is provided with an internal gas inlet for the supply of an inert gas such as argon in the main chamber 2 near the magnetron heads. The gases into the main chamber 2 may be controlled using mass flow controllers.

An access chamber 11, which in the example is of 100 litre capacity, is arranged between the control rack 9 and the main chamber 2. The access chamber has a removeable lid 12 with viewport 13. Substrates can be loaded via either the access chamber 11 or the loading chamber 3.

The main chamber 2, access chamber 12 and loading chamber 3 may all be formed of stainless steel.

An RF generator unit 40 may be provided to plasma clean the substrate in an oxygen atmosphere prior to sputtering being carried out with the oxygen atmosphere oxidising surface contaminants.

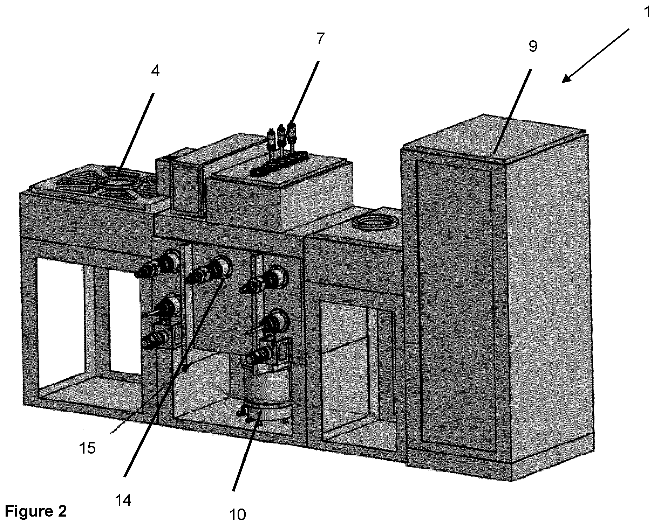

Figure 2 shows the reverse of the sputtering apparatus of Figure 1. Those parts shown and described in relation to Figure 1 will not be described again.

In Figure 2, the substrate feed unit 14 is shown which is provided on a slide mechanism 15 so that the whole feed unit 14 can be slid out of the sputtering apparatus in order to load substrate materials.

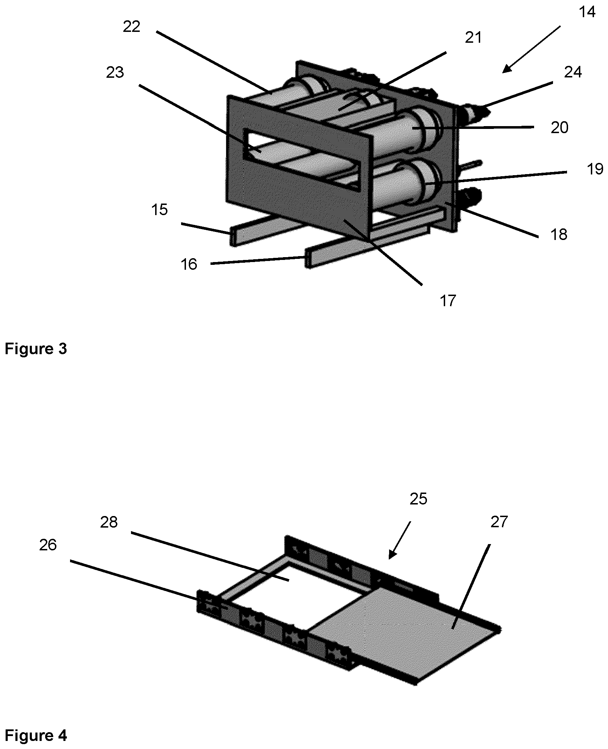

Figure 3 shows further detail of the substrate feed unit 14 which comprises a plurality of rollers 19, 20, 22, 23 which can provide a reel to reel supply of sheet material under the magnetron array 7 in the main chamber 2. One or more of the rollers 19, 20, 22, 23 may be water cooled and each roller respectively driven by a water cooled motor 24 arranged external main chamber 2. In the example, the feed unit 14 can operate with substrates of 400mm in width.

A substrate support 21 is provided to support the substrate as it passes under the magnetron array 7.

Sliders 15 and 16 allows the substrate feed unit 14 to be slide out of the main chamber 2 in order to load material and facilitate maintenance of the apparatus.

The rollers and/or the loading of substate may allow for the substrate to be fed past the magnetron array 7 on both sides of the substrate.

Figure 4 shows a sliding tray 25 which may be provided for feeding planar substrates to the sputtering apparatus. The sliding tray 25 includes a sliding frame 26 within aperture 28 with tray 27 which slides within sliding frame 26 over aperture 28. In the example, the tray may support planar substrates that are 400mm wide, 700mm long and 50mm thick.

It will of course be understood that the dimensions of the tray and/or feed unit and the chambers of the sputtering apparatus may be chosen and designed for substrates of different sizes depending on the desired application.

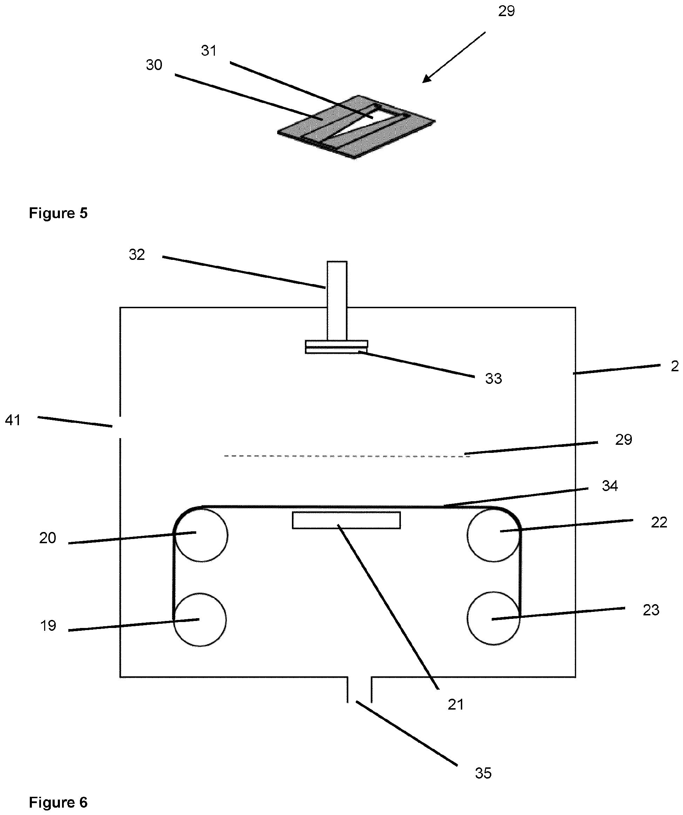

Figure 5 shows a mechanical filter comprising a mask 30 with aperture 31 that may be provided within the main chamber under the sputtering magnetron array 7 in order to restrict the deposition of material onto the substrate. The filter can be used to control the material thickness of the deposited material over parts of the substrate.

Figure 6 shows a schematic of the inside of the main chamber 2. The main chamber 2 has an outlet 35 connected to a vacuum pump for removing air from the main chamber.

The substrate 34 is supplied on feed rollers 19, 20, 22, 23 for delivering the substrate material under the array of sputtering magnetrons which are arranged in a linear array extending into the plane of the paper.

The substrate material 34 may be any suitable material, for example, a film or roll of substrate such as polymeric sheets such as polyethylene, PTE. Other materials may include webs and glass scrims comprising a arrange of glass fibre on a polymeric matrix. The substate material may be as wide as the rollers in to the feed unit and several meters long.

Each sputtering magnetron 32 is provided with its own power supply and may be arranged on a frame or other support for adjusting both the standoff distance, i.e. the height of the magnetron above the substate 34, and/or spacing between adjacent sputtering magnetrons. The height and spacing may be adjusted typically to mm accuracy. The frame may comprise slots within which the magnetrons may be moved. This height and spacing adjustment of each magnetron may be manual and the positioned fixed for example with mechanical fixings such as bolts or the height and spacing adjustment may be automated for example through the use of stepper motors. Typically, the height and spacing is adjusted before a sputtering process. Increasing the distance of the magnetron and target from the substrate, can produce a wider deposition of material.

Each sputtering magnetron is provided with an associated target 33 in the form of a disc. The discs for each sputtering magnetron may all be of the same material and may include metals, metal alloys, and metal oxides amongst others. Targets of different materials may also be used for targeting simultaneously in the same pass or used in subsequent passes of the substrate under the magnetron array. This may allow the production of a desired material mix or alloy in the deposition or a desired layering of materials on the substate. The thickness of deposited layers can typically be in the range of a few nanometres to 1 micrometre.

One or more additional gas injection ports 41 may be provided for the supply of an additional gas. These injection ports 41 may be provided towards or at one side of the chamber and/or at the end of the chamber.

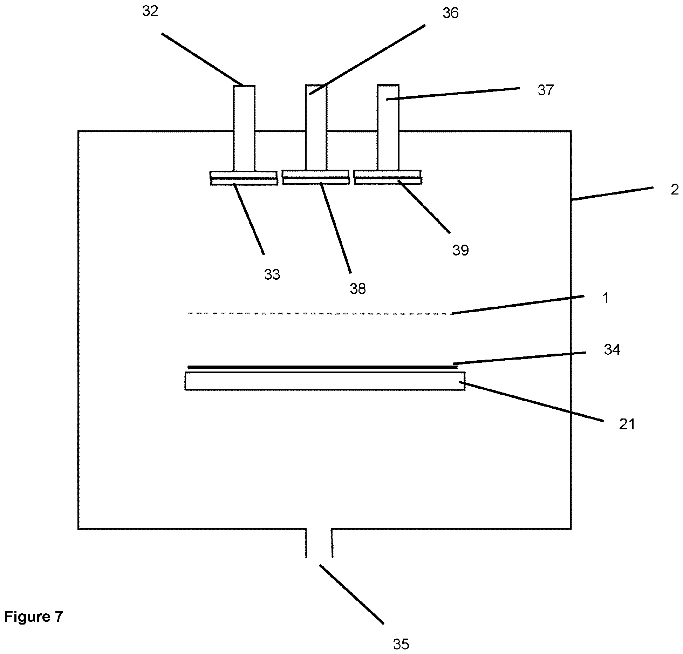

Figure 7 shows a view perpendicular to that shown in Figure 6 with three sputtering magnetrons 32, 36 and 37 arranged in a linear array across the substate 34. In operation, the substate moves into the plane of the paper. Each of the sputtering magnetrons has an associated sputtering target 33, 38, 39.

While in the example, a linear array of three sputtering magnetrons is provided, the magnetron array may include any number of sputtering magnetrons depending on the substate upon which material is to be deposited. In addition, a rectangular or square array of sputtering magnetrons may be provided.

In operation, the main chamber 2 is evacuated and is filled with an inert gas such as argon.

The substrate is fed at a controlled rate under the array of sputtering magnetrons. The substrate is mechanically supported under the magnetron array 7 by substrate support 21.

The magnetron energises the inert gas to create a plasma, which in the case of argon as the inert gas, comprises argon ions and electrons. The positively charged argon ions are accelerated and collide or bombard the targets associated with each magnetron in the array. This causes atoms of the target material to be sputtered and deposited on the substrate. The power supplied to each sputtering magnetron 32 and its duration can be controlled in order to produce a desired thickness of material deposition both linearly and laterally on the substate as it passes. Some of the magnetrons in the array may also be selectively switched off as the substate passes depending on the desired material deposition.

The mechanical filter 29 may also be used to control the thickness of material deposition.

The thickness of the material deposition may be built up through successive passes of the substate under the magnetron array.

When a gas injection port is provided towards or at one side, or at one end of the chamber, a gas concentration gradient can be provided across the chamber such that when the substrate material moves through the chamber it will experience a gradient of gas. This can allow a gradient to any treatment or coating that is being performed on the substrate as it moves through the chamber. This can provide different material properties across the substrate, by changing the reactive gas concentration at different portions of the substrate whilst material is being deposited. The gas may be an etchant gas. Such etching may be carried out in an argon or other suitable atmosphere with the etching controlled using the magnetron array.

Further, the apparatus may be used for reactive sputtering, through the introduction of traces of a reactive gas or substance, including non-inert gases such as oxygen and nitrogen, in addition to or instead of the inert gas, in order to facilitate alternative material deposition. As an example, silicon nitride can be produced by introducing a nitrogen flow into the chamber which would react with sputtered silicon. Oxygen can be introduced to produce silicon oxide. Without the introduction of nitrogen or oxygen gas only a silicon layer would be deposited. The non-inert gas can be introduced uniformly into the chamber or the gradient of the non-inert gas can be controlled by introducing the non-inert gas through a gas injection port on one side of the chamber.

By controlling the power to respective magnetrons the thickness of the deposited material layer can be varied. The magnetron separation and standoff distance from the target or substrate can also be varied to adjust the thickness of the deposited material layer. By controlling one or more of the power, standoff distance and magnetron separation, a desired material deposition thickness may be achieved. The controller can be configured to adjust one or more of the power, standoff distance and magnetron separation. The controller can be used to vary the power to each individual magnetron as the substrate is fed through the apparatus. In addition, the feed rate and direction of the substate can be controlled. This can achieve varying thickness in the material deposition across the substrate.

The provision of an array of magnetrons advantageously allows for the material disposition thickness to be controlled laterally across the substate and longitudinally during single passes of the substrate. With the substrate being fed on a feed roller, it is possible to deposit material over large areas of substrate.

The additional control of the individual magnetrons, for example in terms of power, height and spacing within the magnetron array allows for even greater flexibility in the material deposition thickness.

## Claims

1. A sputtering apparatus comprising a vacuum chamber and a magnetron array comprising an array of two or more magnetrons for bombarding associated sputtering targets.

2. A sputtering apparatus according to claim 1, wherein said magnetron array comprises a linear array of magnetrons.

3. A sputtering apparatus according to claim 1, wherein said magnetron array comprises a rectangular or square array of magnetrons.

4. A sputtering apparatus according to any preceding claim, wherein the spacing between adjacent magnetrons in the magnetron array is adjustable.

5. A sputtering apparatus according to any preceding claim, wherein the height from a substrate of one or more of the magnetrons in the magnetron array is adjustable.

6. A sputtering apparatus according to any preceding claim comprising a controller configured to control the voltage applied to each magnetron in said magnetron array.

7. A sputtering apparatus according to any preceding claim comprising a feed roller for feeding a substrate material under said magnetron array.

8. A sputtering apparatus according to claim 7, wherein the feed roller comprises a reel to reel arrangement of rollers.

9. A sputtering apparatus according to any of claims 1 to 8, further comprising a sliding feed tray.

10. A sputtering apparatus according to any of the preceding claims, comprising one or more gas injection ports.

11. A sputtering apparatus according to claim 10, wherein the one or more gas injection ports are provided offset or to one side or at the end of the vacuum chamber.

12. A method of magnetron sputtering using the apparatus as claimed in any of the preceding claims, the method comprising feeding a substate material past said magnetron array.

13. A method of magnetron sputtering as claimed in claim 12, the method including adjusting one or more of the power, height and spacing of the sputtering magnetrons in the magnetron array.

14. A method as claimed in claim 12 or 13, wherein the substate comprises a polymeric film or glass scrim.

15. A method as claimed in any of claims 12 to 14, further including introducing a non-inert gas into the chamber.

16. A method as claimed in claim 15, wherein a gas is introduced at or towards one side or at the end of the chamber to provide a gas gradient across the substrate as it moves through the chamber.

17. A method as claimed in any of claims 12 to 16, the method including sputter etching and/or oxygen cleansing of the substrate.
